# EUROPEAN PATENT SPECIFICATION

(11) **EP 0 385 469 B1**
(45) Date of publication and mention of the grant of the patent: **26.04.1995**
(21) Application number: 90104010.5
(22) Date of filing: 01.03.1990
(51) Int. Cl.: G05F 3/24, G11C 16/06, G11C 5/14

(54) **Potential detecting circuit**
Spannungsabfühlschaltung
Circuit de détection de potentiel

(30) Priority: 03.03.1989 JP 51711/89
(43) Date of publication of application: 05.09.1990
(73) Proprietor: KABUSHIKI KAISHA TOSHIBA, Kawasaki-shi, Kanagawa-ken 210 (JP)
(72) Inventor: Takiba, Akira, c/o Intellectual Property Div., Minato-ku, Tokyo 105 (JP); Matsumoto, Osamu, c/o Intellectual Property Div., Minato-ku, Tokyo 105 (JP); Saeki, Yukihiro, c/o Intellectual Property Div., Minato-ku, Tokyo 105 (JP)
(74) Representative: Lehn, Werner, Dipl.-Ing.

(56) References cited:
- EP-A- 0 090 116
- US-A- 4 626 704
- PATENT ABSTRACTS OF JAPAN vol. 5, no. 185 (P-91)(857) 25 November 1981 & JP-A-56 114 198 NIPPON DENKI K.K.) 8 September 1981

## Description

The present invention relates to a potential detecting circuit comprising:
a first MOS transistor of a first conductivity type whose drain receives an input potential which is equal to or lower, in absolute value, than a second potential whose absolute value is greater than that of a first potential;
a second MOS transistor of a second conductivity type whose source is connected to the source of said first transistor and whose gate receives said first potential;
a third MOS transistor of the first conductivity type whose drain is connected to the drains of said second MOS transistor, whose source receives a reference potential with an absolute value which is less than that of said first potential, and whose gate receives said first potential; and
a potential detect output terminal for providing a detected potential, said potential detect output terminal being a junction point between the drains of said second and third MOS transistors. Such a circuit is described in US-A-4 626 704.

The present invention is applicable for detecting a potential which is similar to the power source potential of a CMOS LSI, and a potential which is much higher than the reference potential or the power source potential of the CMOS LSI.

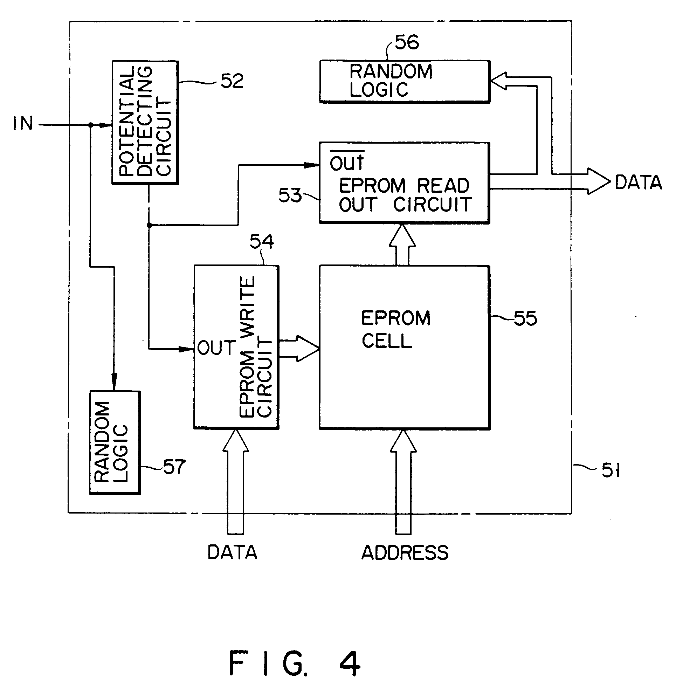

Another circuit of interest is described in EP-A-0 090 116. In an LSI with a nonvolatile memory, for example an EPROM, it is required that a write mode be changed to a read mode, and vice versa. To operate the LSI in the write mode, an externally applied voltage Vₚₚ, which is much higher than the LSI power source V_{DD} potential, is required. A protection transistor (Q19 in Fig. 4) is provided to prevent that the high voltage Vₚₚ appears at transistors not designed to be operated with such a high voltage.

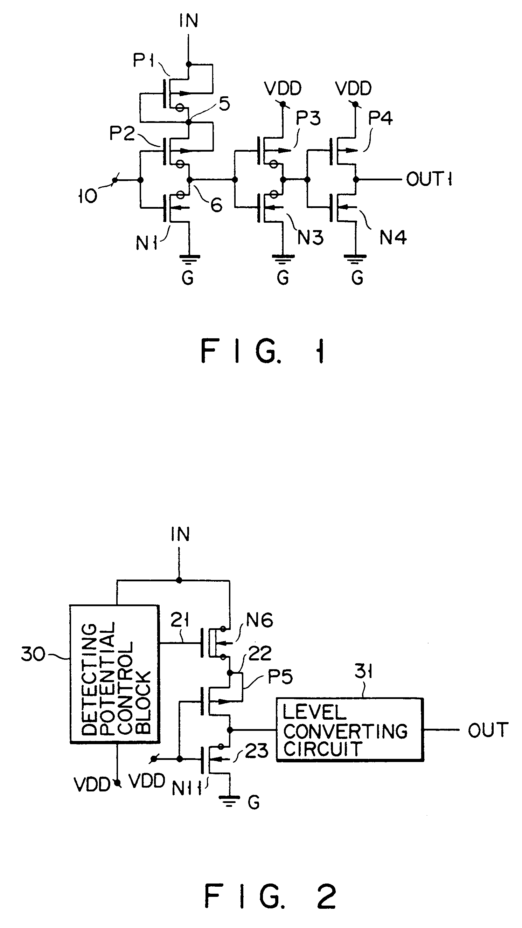

Fig. 1 shows another prior art potential detecting circuit. In this circuit, an input terminal IN for receiving an input potential VIN is grounded through PMOS transistors P1 and P2 and an MNOS transistor N1. A potential detection signal is derived from an output terminal Out1, through an inverter consisting of two pairs of MOS transistors P3 and N3, and P4 and N4.

The high breakdown voltage transistor is different from the transistor of the VDD system in the following respects:
1) The high breakdown voltage transistor has an LDD (lightly doped drain) structure.
2) The high breakdown voltage transistor has a thick gate oxide film.

In Fig. 1, the MOS transistors of the LDD structure are indicated by small circles attached to the drains.

Let us consider two different operations of the prior art potential detecting circuit shown in Fig. 1, when the input potential of the circuit is equal to an LSI power source, high potential Vₚₚ, e.g., 20 V, which is much higher than an LSI power source, low potential V_{DD}, e.g., 5 V, and when the input potential is equal to the power source potential V_{DD}.
a) When the high potential Vₚₚ (20 V) is applied to the input terminal IN, a potential at node 5 is lower than the potential Vₚₚ by the amount of the threshold voltage V_{THp1} of the PMOS transistor P1. If the potential at node 5 is higher than a sum of the threshold voltage V_{THp2} of the PMOS transistor P2 and the gate potential V_{DD}, the PMOS transistor P2 is turned on. Under this condition, a current flows from the input terminal IN to the ground point G through the PMOS transistors P1 and P2 and the NMOS transistor N1. The potential at node 6 progressively rises by a ratio of the sum of the ON-resistance of the PMOS transistors P1 and P2 to the ON-resistance of the NMOS transistor N1.
   i) When the potential at node 6 is higher than the threshold voltage of the inverter including the MOS transistors P3 and N3, a potential at the V_{DD} level is output from the output terminal Out1. ii) When the former is lower than the latter. A ground level potential is output from the output terminal Out1.
b) When a potential V_{DD} equal to or lower than the potential Vₚₚ is applied to the input terminal IN, the potential at node 5 is lower than a sum of the threshold voltage V_{TH2} of the PMOS transistor P2 and the gate potential V_{DD}. Therefore, the transistor P2 remains off while the transistor N1 remains on. Accordingly, a ground level potential is output from the output terminal Out1.

In this way, the potential detecting circuit can detect the input potential V_{IN}, the high potential Vₚₚ, or the low potential V_{DD}. The potential detecting circuit is characterized in that, even when a potential between the ground level and the V_{DD} level is applied to the input terminal, the PMOS transistor P2 is turned off, and hence no DC path is formed. It is also characterized in that the drains of the transistors P3 and N3 are of the LDD structure type and can withstand a high potential applied to the gates of those transistors.

To assemble the circuit, including the high breakdown voltage PMOS transistor P2 and the like as shown in Fig. 1, into an LSI chip which does not use high breakdown voltage PMOS transistors, another type of transistors must be used. This means that the number of manufacturing process steps must increase. In this regard, it should be noted that to manufacture an LSI containing elements such as E²PROM, polysilicon electrodes for the V_{DD} system and those for the high breakdown voltage cells are separately formed. In this case, the following additional three steps are performed in the photo etching process:
a) To implant ions into the channels of high breakdown voltage PMOS transistors,
b) To form the LDD structure of high breakdown voltage NMOS transistors by using a mask, and
c) To form the LDD structure of high breakdown voltage PMOS transistors by using a mask.

It is evident that the increased number of process steps leads to an increase in the manufacturing cost and manufacturing time.

Accordingly, an object of the present invention is to provide a potential detecting circuit capable of detecting a high potential (whose absolute value is great, in comparison with the negative potential) in an LSI of the type in which high breakdown voltage PMOS (or NMOS) transistors having a high breakdown structure such as the LDD structure are not required.

According to the invention, the potential detecting circuit initially defined is characterized by:
a detecting potential control block for applying a potential varying in accordance with said input potential to the gate of said first MOS transistor.

A structure capable of withstanding the application of a high potential is not required for the second MOS transistor.

Thus, in an LSI with different power sources, the potential detecting circuit can detect a potential higher, in absolute value, than the potential V_{DD}, and can comprise the high breakdown voltage MOS transistors of the first conductivity type and the transistors of the second conductivity type used in the V_{DD} (normal MOS LSI power source) system, rather than the high breakdown voltage MOS transistors of the second conductivity.

This invention can be more fully understood from the following detailed description when taken in conjunction with the accompanying drawings, in which:
Fig. 1 is a circuit diagram showing a conventional potential detecting circuit;
Fig. 2 is a circuit diagram showing a potential detecting circuit according to an embodiment of the present invention;
Fig. 3 is a circuit diagram showing the details of the potential detecting circuit of Fig. 2;
Fig. 4 is a block diagram of an EPROM-contained LSI into which a potential detecting circuit according to the present invention is assembled;
Fig. 5 is a circuit diagram showing a potential detecting circuit according to another embodiment of the present invention; and
Fig. 6 is a circuit diagram showing a potential detecting circuit according to another embodiment of the present invention.

Some specific embodiments of the present invention will be described with reference to the accompanying drawings.

Fig. 2, illustrates a high potential detecting circuit according to an embodiment of the present invention. In Fig. 2, the same components as those shown in Fig. 1 (prior art) are designated by the same symbols for simplicity. In Fig. 2, reference numeral 30 denotes a detecting potential control block. When the potential Vₚₚ, which is much higher than the LSI power source potential V_{DD}, is applied to an input terminal IN, the detecting potential control block 30 produces at its output terminal 21 a potential higher than the potential V_{DD}. When a potential lower than the potential V_{DD} or higher, but not much higher, than the potential V_{DD} is applied to the input terminal, the block 30 produces the potential V_{DD} at its output termi nal 21. Reference numeral 31 indicates a level converting circuit. A level converting circuit 31 changes the potential appearing at an input terminal 23 to a potential of "V_{DD} - ground potential". The input terminal IN is connected to the drain of a D-type (depletion-type) NMOS transistor N6. The transistors, which are NMOS and PMOS transistors, are of the E-type (enhancement-type). The source of the D-type NMOS transistor N6 is connected to the source and the back gate of a PMOS transistor P5. The gate of the transistor N6 is connected to the output terminal 21 of the detecting potential control circuit 30. The gates of the PMOS transistor P5 and the NMOS transistor N11 are connected to the potential V_{DD}. The source of the transistor N11 is grounded. The potential applied to the input terminal IN passes through the level converting circuit 31, and is out-putted in the form of a detected potential, from the output terminal Out.

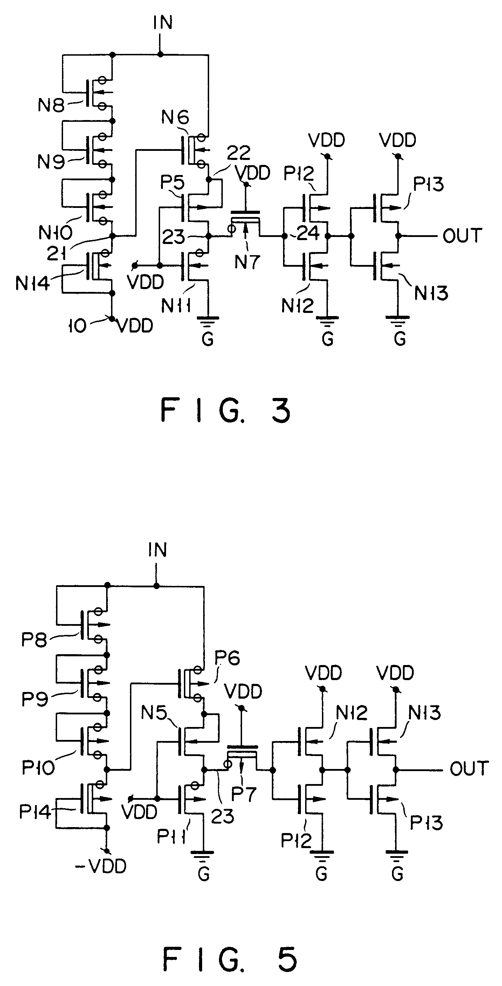

The potential detecting circuit of Fig. 2 is illustrated in detail in Fig. 3. The detecting potential control block 30 shown in Fig. 2 is arranged as follows. The input terminal IN is connected to the drain and the gate of an NMOS transistor N8. The source of the transistor N8 is connected to the drain and the gate of an NMOS transistor N9. The source of the transistor N9 is connected to the drain and the gate of the NMOS transistor N10. The source of the transistor N10 is connected to the drain of the D-type NMOS transistor N14. The source and the gate of the transistor N14 is connected to the potential V_{DD}.

The level converting circuit 31 shown in Fig. 2 has the structure described as follows. The input terminal 23 is connected to the drain of a D-type transistor N7. The gate of the transistor N7 is connected to the potential V_{DD}, and the source of the transistor N7 is connected to the input terminal of an inverter has a PMOS trnasistor P12 and an NMOS transistor N12. As output terminal of the inventer is connected to an output terminal out of an inverter having PMOS transistor P13 and NMOS trnasistor N13.

In the circuit of Fig. 3, as is understood from mark o, the LDD structure is employed for the sources and the drains of the NMOS transistors N8, N9, and N10, and the D-type NMOS transistor N6, and the drains of the NMOS transistor N11 and the D-type NMOS transistors N14, and N7. It is noted here that the PMOS transistor P5 is a normal V_{DD} system transistor and, unlike the PMOS transistor P2 in Fig. 1, does not employ the LDD structure for the drain.

Operations of two modes of the potential detecting circuit thus arranged and shown in Fig. 3 will be described.
a) A first operation mode of the potential detecting circuit starts when a potential lower than the potential V_{DD} is applied to the input terminal IN.
   In this mode, the source and the gate of the NMOS transistor N14 are both at the V_{DD} level. Accordingly, the potential V_{DD} in applied at the node 21 between the drain of the transistor N14 and the source of the NMOS transistor 10. At this time, the potential lower than the potential V_{DD} has been applied to the input terminal IN. Accordingly, no current flows through the current paths of the NMOS transistors N8 to N10, because those transistors are reversely biased. Since the potential at the node 21 is applied to the gate of the D-type NMOS transistors N6, the transistor N6 is turned on, and the potential lower than V_{DD} at the input terminal IN is applied the source of the PMOS transistor P5 via the transistor N6. At this time, the potential V_{DD} has been applied to the gate of the PMOS transistor P5, and hence the transistor P5 is turned off. The potential V_{DD} has also been applied to the gate of the transistor N11, which has been turned on. Accordingly, the node 23 is pulled down to the ground potential. This potential goes through the D-type NMOS transistor N7, which has been in an on state because the potential V_{DD} is applied to the gate thereof, and the two-stage inverter, and applied at the output terminal Out. Accordingly, when the potential below the V_{DD} level is applied to the input terminal IN, the output terminal Out provides the potential of the ground level.
b) A second operation mode of the potential detecting circuit starts when the potential Vₚₚ (which is much higher than the potential V_{DD}.
   When the potential Vₚₚ is applied to the input terminal IN, a potential at the node 21 is determined by the back-gate effect of the NMOS transistors N8 to N10, and the ON-resistance of the D-type NMOS transistor N14. Since the potential at the node 21 is applied to the gate of the transistor N6, a potential at a node 22 is expressed as "(potential at node 21) + |(threshold voltage V_{TH} of transistor N6 influenced by the back-gate effect)|". Thus, the detecting potential control block 30 is a circuit for determining a potential at the node 22 and controlling the potential so as not to degrade the PMOS transistor P5. Since the potential at the source and gate of the PMOS transistor P5 is higher than "V_{DD} + |threshold voltage V_{TH} of the PMOS transistor P5|" when the potential at the node 22 rises, the transistor P5 is turned on, and a potential at the input terminal 23 is determined by a ratio of the ON-resistance of the transistor P5 and that of the NMOS transistor N11 which has been already turned on. The potential at node 24 connected to the source of D-type NMOS transistor N7, which is turned on by applying potential V_{DD} to the gate thereof, is substantially equal to a potential at input terminal 23. The potential at the node 24 is controlled to be below "V_{DD} + |threshold voltage V_{TH} of transistor N7 influenced by the back gate effect|", thereby protecting the PMOS transistor P12 and NMOS transistor N12 from its gate breakdown, e.g., breakage of the gate insulating film. This fact implies that there is no need for introducing the high breakdown voltage structure to the PMOS transistor P12 and NMOS N12, although the potential detecting circuit of Fig. 1 uses such a measure, or the LDD structure.

The potential at the node 24 increases higher than the threshold voltage of the inverter consisting of the PMOS transistor P12 and the NMOS trnasistor N12, and goes through the two-stage inverter consisting of the paired transistors P12 and N12, and P13and N13, and appears as the potential of the V_{DD} level at the output terminal Out. The potential of V_{DD} level is output from the output terminal Out. It is thus detected that a high potential Vₚₚ is applied to the input terminal In.

The circuit shown in Fig. 3 has the following feature. When the potential level is between the ground potential and the potential V_{DD}, no current flows through the current path consisting of the NMOS transistors N8 to N10, as already stated.

As seen from the foregoing description, the potential detecting circuit according to the embodiment shown in Fig. 3 is constructed by using E- and D-type NMOS transistors and the PMOS transistors (particularly, the transistor P5) of the V_{DD} system, not the high breakdown voltage PMOS transistor like the PMOS transistor P2 in the prior art of Fig. 1. The potential detecting circuit thus constructed is capable of detecting a high potential. Accordingly, when the potential detecting circuit is assembled into the LSI not using the high breakdown voltage MOS transistors with the LDD structure, the manufacturing time is reduced, the production yield is improved, and the cost to manufacture is reduced. Further, when the input potential is between the ground potential and the potential V_{DD}, no current path is formed between the high and low power sources. The input impedance of the circuit is extremely high. Therefore, the input terminal IN may be used for another terminal, for example, data input terminal.

An LSI having an EPROM into which a potential detecting circuit according to the present invention is incorporated, will be described with reference to Fig. 4. In the figure, reference numeral 51 designates an LSI chip; 52, a potential detecting circuit according to the present invention; 53, an EPROM read out circuit; 54, an EPROM write circuit; 55, an EPROM cell array; 56, 57, random logics. The potential V_{DD} at the output terminal Out of the potential detecting circuit 52 drives the write circuit 54, while the ground potential at the output terminal Out drives the read out circuit 53.

The write circuit 54 is for writing data into the EPROM cell array 55. The read out circuit 53 reads data from the cell array 55. To separately operate the read and write circuits, it is necessary to change a read mode to a write mode and vice versa. To this end, a select signal Vₚₚ is used, and the potential detecting circuit 52 which operates in response to the select signal is provided. In this case, such an operation of the potential detecting circuit suffices that it produces the V_{DD} potential for the potential of the Vₚₚ level, and produces ground potential for the input potential of the V_{DD} level or less. Alternatively, the reversed case is also allowed. In the Fig. 4 circuit, the EPROM write circuit 54 goes into an active state when the output from the potential detecting circuit 52 is at level V_{DD}. The read out circuit 53 goes into an active state when the output from the potential detecting circuit 52 is at the ground potential level. With such an arrangement, the write mode and the read mode may be selectively set up by applying the potential Vₚₚ or V_{DD} to one of the input terminals IN of the LSI, which connects to the potential detecting circuit 52 contained therein. Thus, the input potential applied to the potential detecting circuit 52 is applied from the outside of the LSI chip, and the output potential of the circuit 52 is used for selecting the read mode or the write mode within the LSI. In this instance, when the input terminal is at a potential of the V_{DD} level or less, it serves as an input terminal to the random logic 57.

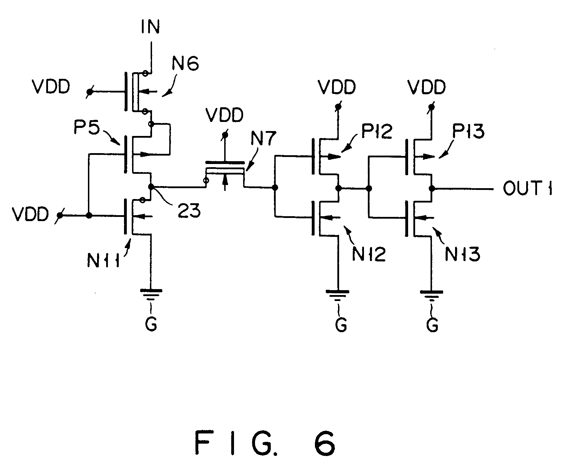

It should be understood that the present invention is not limited to the specific embodiments as mentioned above, but may be variously changed and modified within the scope of the present invention. While the embodiment as described with reference to Figs. 2 and 3 is the high potential detecting circuit, the present invention may also be embodied into a low potential detecting circuit as shown in Fig. 5. Here, the term "low potential" means a potential much lower than potential - V_{DD}. An arrangement of the low potential detecting circuit of Fig. 5 is featured in that the PMOS transistors are replaced by the NMOS transistors, and the potential V_{DD} is replaced by the potential - V_{DD}. The arrangement of the Fig. 5 may readily be understood on the analogy of the arrangement of the high potential detecting circuit of Figs. 2 and 3. The reference symbols denoting the transistors in Fig. 4 are replaced characters, P by N, or vice versa followed by the same numerals as those in Figs. 2 and 3. The operation of the low potential detecting circuit of Fig. 5 will be understood with the reversed polarity. The detect voltage controller 30 is operable with only two transistors (specifically, the transistors P8 and P9 are omissible, if required).

The detecting potential control block 30, which is designed to control a desired detecting potential, can be of any circuit which can control such a potential. Further, the block 30 can be dispensed with, as is shown in Fig. 6, depending upon the value of the detecting potential. Moreover, the gate input of the DMOS transistor N6 can be a fixed potential, for example, V_{DD} (the first potential).

## Claims

1. A potential detecting circuit comprising:
a first MOS transistor (N6, P6) of a first conductivity type whose drain receives an input potential which is equal to or lower, in absolute value, than a second potential whose absolute value is greater than that of a first potential;
a second MOS transistor (P5, N5) of a second conductivity type whose source is connected to the source of said first transistor and whose gate receives said first potential;
a third MOS transistor (N11, P11) of the first conductivity type whose drain is connected to the drain of said second MOS transistor (P5, N5), whose source receives a reference potential with an absolute value which is less than that of said first potential, and whose gate receives said first potential; and
a potential detect output terminal (23) for providing a detected potential, said potential detect output terminal being a junction point between the drains of said second and third MOS transistors (P5, N5, N11, P11), characterized by:
a detecting potential control block (30; N5, N8 to N10, p5, P8 to P10) for applying a potential varying in accordance with said input potential to the gate of said first MOS transistor.

2. The potential detecting circuit according to claim 1, characterized in that said first potential is a positive potential, said second potential is another positive potential higher than said first potential, said first conductivity type is an N type, and said second conductivity type is a P type.

3. The potential detecting circuit according to claim 1, characterized in that said first potential is a negative potential, said second potential is another negative potential more negative than said first potential, said first conductivity type is a P type, and said second conductivity type is an N type.

4. The potential detecting circuit according to claim 1, characterized in that the back-gate of said second MOS transistor (P5, N5) is connected to the source of said first MOS transistor (N6, P6).

5. The potential detecting circuit according to claim 1, characterized in that said first MOS transistor (N6, P6) is of the depletion type.

6. The potential detecting circuit according to claim 1, characterized in that said second MOS transistor (P5, N5) is structured not to have a high breakdown voltage.

7. The potential detecting circuit according to claim 1, characterized in that when an absolute value of said input potential is much higher than said first potential, said detecting potential control block produces an output potential determined by said input potential, and when the absolute value of said input potential is higher than said first potential but much lower than said second potential, or when the absolute value of said input potential is lower than said first potential, said detecting potential control block produces said first potential, which is independent of said input potential.

8. The potential detecting circuit according to claim 1, characterized in that said detecting potential control block (30), for producing a potential varying in accordance with said input potential, is arranged such that at least fourth and fifth MOS transistors (N10, N14) of the first conductivity type are connected in series, the source and gate of said fifth MOS transistor are connected to said first potential, a node (21) between said fourth and fifth MOS transistors is used as a potential output terminal connecting to the gate of said first MOS transistor (N6), the gate and drain of said fourth MOS transistor are interconnected, and the drain of said fourth MOS transistor is connected to said input terminal.

9. The potential detecting circuit according to claim 1, characterized in that said potential detect output terminal (23) is connected to a level converting circuit (31) for changing the output potential at said output terminal to said reference potential or a potential of the same level as that of said first potential.

10. The potential detecting circuit according to claim 9, characterized in that said level converting circuit (31) is designed such that said potential detect output terminal (23) is connected to the drain of a sixth MOS transistor (N7) of the first conductivity type, the gate of said sixth MOS transistor (N7) is connected to an input terminal receiving said first potential, and a detect output potential is derived from the source of said sixth MOS transistor (N7), through an inverter (P12, N12, P13, N13).

11. The potential detecting circuit according to claim 3, characterized in that the back-gate of said second MOS transistor (P5, N5) is connected to the source of said first MOS transistor (N6, P6).

12. The potential detecting circuit according to claim 3, characterized in that said first MOS transistor (N6, P6) is of the depletion type.

13. The potential detecting circuit according to claim 3, characterized in that said second MOS transistor (P5, N5) is structured not to have a high breakdown voltage.

14. The potential detecting circuit according to claim 3, characterized in that when an absolute value of said input potential is much higher than said first potential, said detecting potential control block produces an output potential determined by said input potential, and when the absolute value of said input potential is higher than said first potential but much lower than said second potential or, when the absolute value of said input potential is lower than said first potential, said detecting potential control block produces said first potential, which is independent of said input potential.

15. The potential detecting circuit according to claim 3, characterized in that said detecting potential control block (30) for producing a potential varying in accordance with said input potential is designed such that at least fourth and fifth MOS transistors (N10, N14) of the first conductivity are connected in series, the source and gate of said fifth MOS transistor are connected to said first potential, a node between said fourth and fifth MOS transistors is used as a potential output terminal connecting to the gate of said first MOS transistor, the gate and drain of said fourth MOS transistor are interconnected, and the drain of said fourth MOS transistor is connected to said input terminal.

16. The potential detecting circuit according to claim 3, characterized in that said potential detect output terminal (23) is connected to a level change circuit (31) for changing the output potential at said output terminal to said reference potential or a potential of the same level as that of said first potential.

17. The potential detecting circuit according to claim 16, characterized in that said level converting circuit (31) is designed such that said potential detect output terminal (23) is connected to the drain of a sixth MOS transistor (N7) of the first conductivity type, the gate of said sixth MOS transistor (N7) is connected to an input terminal receiving said first potential, and a detect output potential for said input potential is derived from the source of said sixth MOS transistor (N7), through an inverter (P12, N12, P13, N13).

## Patentansprüche

1. Potentialerfassungsschaltung, umfassend:
einen ersten MOS-Transistor (N6, P6) eines ersten Leitfähigkeitstyps, dessen Drain ein Eingangspotential empfängt, welches im absoluten Wert gleich oder niedriger als ein zweites Potential ist, dessen absoluter Wert größer als derjenige eines ersten Potentials ist;
einen zweiten MOS-Transistors (P5, N5) eines zweiten Leitfähigkeitstyps, dessen Source mit der Source des ersten Transistors verbunden ist und dessen Gate das erste Potential empfängt;
einen dritten MOS-Transistor (N11, P11) des ersten Leitfähigkeitstyps, dessen Drain mit der Drain des zweiten MOS-Transistors (P5, N5) verbunden ist, dessen Source ein Referenzpotential mit einem absoluten Wert empfängt, der geringer als derjenige des ersten Potentials ist, und dessen Gate das erste Potential empfängt; und
einen Potentialerfassungs-Ausgangsanschluß (23) zur Bereitstellung eines erfaßten Potentials, wobei der Potentialerfassungs-Ausgangsanschluß ein Übergangspunkt zwischen den Drains der zweiten und dritten MOS-Transistoren (P5, N5, N11, P11) ist,
**gekennzeichnet** durch:
einen Potentialerfassungs-Steuerblock (30; N5, N8 bis N10, P5, P8 bis P10) zur Anlegung eines Potentials, welches sich in Abhängigkeit von dem Eingangspotential verändert, an das Gate des ersten MOS-Transistors.

2. Potentialerfassungsschaltung nach Anspruch 1, dadurch **gekennzeichnet**, daß das erste Potential ein positives Potential ist, das zweite Potential ein positives Potential höher als das erste Potential ist, der erste Leitfähigkeitstyp ein N-Typ ist und der zweite Leitfähigkeitstyp ein P-Typ ist.

3. Potentialerfassungsschaltung nach Anspruch 1, dadurch **gekennzeichnet**, daß das erste Potential ein negatives Potential ist, das zweite Potential ein anderes negatives Potential negativer als das erste Potential ist, der erste Leitfähigkeitstyp ein P-Typ ist und der zweite Leitfähigkeitstyp ein N-Typ ist.

4. Potentialerfassungsschaltung nach Anspruch 1, dadurch **gekennzeichnet**, daß das Rückgate des zweiten MOS-Transistors (P5, N5) mit der Source des ersten MOS-Transistors (N6, P6) verbunden ist.

5. Potentialerfassungsschaltung nach Anspruch 1, dadurch **gekennzeichnet,** daß der erste MOS-Transistor (N6, P6) vom Verarmungstyp ist.

6. Potentialerfassungsschaltung nach Anspruch 1, dadurch **gekennzeichnet**, daß der zweite MOS-Transistor (P5, N5) strukturiert ist, so daß er keine hohe Durchbruchspannung aufweist.

7. Potentialerfassungsschaltung nach Anspruch 1, dadurch **gekennzeichnet**, daß, wenn ein absoluter Wert des Eingangspotentials viel höher als das erste Potential ist, der Potentialerfassungs-Steuerblock ein durch das Eingangspotential bestimmtes Ausgangspotential erzeugt, und wenn der absolute Wert des Eingangspotentials höher als das erste Potential, aber viel niedriger als das zweite Potential ist, oder wenn der absolute Wert des Eingangspotentials niedriger als das erste Potential ist, der Potentialerfassungs-Steuerblock das erste Potential erzeugt, welches von dem Eingangspotential unabhängig ist.

8. Potentialerfassungsschaltung nach Anspruch 1, dadurch **gekennzeichnet**, daß der Potentialerfassungs-Steuerblock (30) zur Erzeugung eines Potentials, welches sich in Abhängigkeit von dem Eingangspotential verändert, so angeordnet ist, daß wenigstens vierte und fünfte MOS-Transistoren (N10, N14) des ersten Leitfähigkeitstyps in Reihe geschaltet sind, die Source und das Gate des fünften MOS-Transistors mit dem ersten Potential verbunden sind, ein Knotenpunkt (21) zwischen den vierten und fünften MOS-Transistoren als ein Potentialausgangsanschluß verwendet wird, der mit dem Gate des ersten MOS-Transistors (N6) verbunden ist, das Gate und die Drain des vierten MOS-Transistors zusammengeschaltet sind und die Drain des vierten MOS-Transistors mit dem Eingangsanschluß verbunden ist.

9. Potentialerfassungsschaltung nach Anspruch 1, dadurch **gekennzeichnet**, daß der Potentialerfassungs-Ausgangsanschluß (23) mit einer Pegelumwandlungsschaltung (31) verbunden ist, um das Ausgangspotential an dem Ausgangsanschluß auf das Referenzpotential oder ein Potential des gleichen Pegels wie das des ersten Potentials zu ändern.

10. Potentialerfassungsschaltung nach Anspruch 9, dadurch **gekennzeichnet**, daß die Pegelumwandlungsschaltung (31) so ausgelegt ist, daß der Potentialerfassungs-Ausgangsanschluß (23) mit der Drain eines sechsten MOS-Transistors (N7) des ersten Leitfähigkeitstyps verbunden ist, das Gate des sechsten MOS-Transistors (N7) mit einem das erste Potential empfangenden Eingangsanschluß verbunden ist und ein Erfassungsausgangspotential von der Source des sechsten MOS-Transistors (N7) über einen Inverter (P12, N12, P13, N13) abgeleitet wird.

11. Potentialerfassungsschaltung nach Anspruch 3, dadurch **gekennzeichnet**, daß das Rückgate des zweiten MOS-Transistors (P5, N5) mit der Source des ersten MOS-Transistors (N6, P6) verbunden ist.

12. Potentialerfassungsschaltung nach Anspruch 3, dadurch **gekennzeichnet**, daß der erste MOS-Transistor (N6, P6) vom Verarmungstyp ist.

13. Potentialerfassungsschaltung nach Anspruch 3, dadurch **gekennzeichnet**, daß der zweite MOS-Transistor (P5, N5) so strukturiert ist, daß er keine hohe Durchbruchspannung aufweist.

14. Potentialerfassungsschaltung nach Anspruch 3, dadurch **gekennzeichnet**, daß, wenn ein absoluter Wert des Eingangspotentials viel höher als das erste Potential ist, der Potentialerfassungs-Steuerblock ein durch das Eingangspotential bestimmtes Ausgangspotential erzeugt, und wenn der absolute Wert des Eingangspotentials höher als das erste Potential, aber viel niedriger als das zweite Potential ist, oder wenn der absolute Wert des Eingangspotentials niedriger als das erste Potential ist, der Potentialerfassungs-Steuerblock das erste Potential erzeugt, welches von dem Eingangspotential unabhängig ist.

15. Potentialerfassungsschaltung nach Anspruch 3, dadurch **gekennzeichnet**, daß der Potentialerfassungs-Steuerblock (30) zur Erzeugung eines Potentials, welches sich in Abhängigkeit von dem Eingangspotential verändert, so ausgeführt ist, daß wenigstens vierte und fünfte MOS-Transistoren (N10, N14) des ersten Leitfähigkeitstyps in Reihe geschaltet sind, die Source und das Gate des fünften MOS-Transistors mit dem ersten Potential verbunden sind, ein Knotenpunkt zwischen den vierten und fünften MOS-Transistoren als Potentialausgangsanschluß verwendet wird, der mit dem Gate des ersten MOS-Transistors verbunden ist, das Gate und die Drain des vierten MOS-Transistors zusammengeschaltet sind und die Drain des vierten MOS-Transistors mit dem Eingangsanschluß verbunden ist.

16. Potentialerfassungsschaltung nach Anspruch 3, dadurch **gekennzeichnet**, daß der Potentialerfassungs-Ausgangsanschluß (23) mit einer Pegeländerungsschaltung (31) zum Ändern des Ausgangspotentials an dem Ausgangsanschluß auf das Referenzpotential oder ein Potential mit dem gleichen Pegel wie das des ersten Potentials verbunden ist.

17. Potentialerfassungsschaltung nach Anspruch 16, dadurch **gekennzeichnet**, daß die Pegelumwandlungsschaltung (31) so ausgelegt ist, daß der Potentialerfassungsausgangsanschluß (23) mit der Drain eines sechsten MOS-Transistors (N7) des ersten Leitfähigkeitstyps verbunden ist, das Gate des sechsten MOS-Transistors (N7) mit einem das erste Potential empfangenden Eingangsanschluß verbunden ist, und ein Erfassungsausgangspotential für das Eingangspotential von der Source des sechsten MOS-Transistors (N7) über einen Inverter (P12, N12, P13, N13) abgeleitet wird.

## Revendications

1. Circuit de détection de potentiel, comprenant:
- un premier transistor MOS (N6, P6) d'un premier type de conductibilité dont le drain reçoit un potentiel d'entrée qui est égal ou inférieur en valeur absolue à un deuxième potentiel dont la valeur absolue est supérieure à celle d'un premier potentiel;
- un deuxième transistor MOS (P5, N5) d'un deuxième type de conductibilité dont la source est connectée à la source dudit premier transistor et dont la grille reçoit ledit premier potentiel;
- un troisième transistor MOS (N11, P11) du premier type de conductibilité dont le drain est connecté au drain dudit deuxième transistor MOS (P5, N5), dont la source reçoit un potentiel de référence ayant une valeur absolue qui est inférieure à celle dudit premier potentiel, et dont la grille reçoit ledit premier potentiel; et
- une borne de sortie de détection de potentiel (23) pour fournir un potentiel détecté, ladite borne de sortie de détection de potentiel étant un point de jonction entre les drains desdits deuxième et troisième transistors MOS (P5, N5, N11, P11), caractérisé par:
- un bloc de commande de potentiel de détection (30; N5, N8 à N10, P5, P8 à P10) pour appliquer un potentiel variant selon ledit potentiel d'entrée appliqué à la grille dudit premier transistor MOS.

2. Circuit de détection de potentiel selon la revendication 1, caractérisé en ce que ledit premier potentiel est un potentiel positif, ledit deuxième potentiel est un autre potentiel positif supérieur audit premier potentiel, ledit premier type de conductibilité est le type N et ledit deuxième type de conductibilité est le type P.

3. Circuit de détection de potentiel selon la revendication 1, caractérisé en ce que ledit premier potentiel est un potentiel négatif, ledit deuxième potentiel est un autre potentiel négatif plus négatif que ledit premier potentiel, ledit premier type de conductibilité est le type P et ledit deuxième type de conductibilité est le type N.

4. Circuit de détection de potentiel selon la revendication 1, caractérisé en ce que la grille arrière dudit deuxième transistor MOS (P5, N5) est connectée à la source dudit premier transistor MOS (N6, P6).

5. Circuit de détection de potentiel selon la revendication 1, caractérisé en ce que ledit premier transistor MOS (N6, P6) est du type à déplétion.

6. Circuit de détection de potentiel selon la revendication 1, caractérisé en ce que ledit deuxième transistor MOS (P5, N5) est structuré pour ne pas avoir une haute tension de claquage.

7. Circuit de détection de potentiel selon la revendication 1, caractérisé en ce que lorsque la valeur absolue dudit potentiel d'entrée est très supérieure audit premier potentiel, ledit bloc de commande de potentiel de détection produit un potentiel de sortie déterminé par ledit potentiel d'entrée, et lorsque la valeur absolue dudit potentiel d'entrée est supérieure audit premier potentiel, mais très inférieure audit deuxième potentiel, ou lorsque la valeur absolue dudit potentiel d'entrée est inférieure audit premier potentiel, ledit bloc de commande de potentiel de détection produit ledit premier potentiel, qui est indépendant dudit potentiel d'entrée.

8. Circuit de détection de potentiel selon la revendication 1, caractérisé en ce que ledit bloc de commande de potentiel de détection (30), pour produire un potentiel variant selon ledit potentiel d'entrée, est agencé de telle manière qu'au moins des quatrième et cinquième transistors MOS (N10, N14) du premier type de conductibilité soient montés en série, la source et la grille dudit cinquième transistor MOS sont connectés audit premier potentiel, un noeud (21) situé entre lesdits quatrième et cinquième transistors MOS est utilisé comme borne de sortie de potentiel connecté à la grille dudit premier transistor MOS (N6), la grille et le drain dudit quatrième transistor MOS sont interconnectées, et le drain dudit quatrième transistor MOS est connecté à ladite borne d'entrée.

9. Circuit de détection de potentiel selon la revendication 1, caractérisé en ce que ladite borne de sortie de détection de potentiel (23) est connectée à un circuit convertisseur de niveau (31) pour mettre le potentiel de sortie de ladite borne de sortie audit potentiel de référence ou à un potentiel du même niveau que celui dudit premier potentiel.

10. Circuit de détection de potentiel selon la revendication 9, caractérisé en ce que ledit circuit convertisseur de niveau (31) est conçu de telle manière que ladite borne de sortie de détection de potentiel (23) soit connectée au drain d'un sixième transistor MOS (N7) du premier type de conductibilité, la grille dudit sixième transistor MOS (N7) est connectée à une borne d'entrée recevant ledit premier potentiel, et un potentiel de sortie de détection est obtenu à partir de la source dudit sixième transistor MOS (N7) par l'intermédiaire d'un inverseur (P12, N12, P13, N13).

11. Circuit de détection de potentiel selon la revendication 3, caractérisé en ce que la grille arrière dudit deuxième transistor MOS (P5, N5) est connectée à la source dudit premier transistor MOS (N6, P6).

12. Circuit de détection de potentiel selon la revendication 3, caractérisé en ce que ledit premier transistor MOS (N6, P6) est du type à déplétion.

13. Circuit de détection de potentiel selon la revendication 3, caractérisé en ce que ledit deuxième transistor MOS (P5, N5) est structuré pour ne pas avoir une haute tension de claquage.

14. Circuit de détection de potentiel selon la revendication 3, caractérisé en ce que lorsque la valeur absolue dudit potentiel d'entrée est très supérieure audit premier potentiel, ledit bloc de commande de potentiel de détection produit un potentiel de sortie déterminé par ledit potentiel d'entrée, et lorsque la valeur absolue dudit potentiel d'entrée est supérieure audit premier potentiel, mais très inférieure audit deuxième potentiel, ou lorsqeu la valeur absolue dudit potentiel d'entrée est inférieure audit premier potentiel, ledit bloc de commande de potentiel de détection produit ledit premier potentiel, qui est indépendant dudit potentiel d'entrée.

15. Circuit de détection de potentiel selon la revendication 3, caractérisé en ce que ledit bloc de commande de potentiel de détection (30), pour produire un potentiel variant selon ledit potentiel d'entrée, est conçu de telle manière qu'au moins des quatrième et cinquième transistors MOS (N10, N14) du premier type de conductibilité soient montés en série, la source et la grille dudit cinquième transistor MOS sont connectées audit premier potentiel, un noeud situé entre lesdits quatrième et cinquième transistors MOS est utilisé comme borne de sortie de potentiel connectée à la grille dudit premier transistor MOS, la grille et le drain dudit quatrième transistor MOS sont interconnectés, et le drain dudit quatrième transistor MOS est connecté à ladite borne d'entrée.

16. Circuit de détection de potentiel selon la revendication 3, caractérisé en ce que ladite borne de sortie de détection de potentiel (23) est connectée à un circuit de changement de niveau (31) pour mettre le potentiel de sortie de ladite borne de sortie au potentiel de référence ou à un potentiel de même niveau que celui dudit premier potentiel.

17. Circuit de détection de potentiel selon la revendication 16, caractérisé en ce que ledit circuit convertisseur de niveau (31) est conçu de telle manière que ladite borne de sortie de détection de potentiel (23) soit connectée au drain d'un sixième transistor MOS (N7) du premier type de conductibilité, la grille dudit sixième transistor MOS (N7) est connectée à une borne d'entrée recevant ledit premier potentiel, et un potentiel de sortie de détection pour ledit potentiel d'entrée est obtenu à partir de la source dudit sixième transistor MOS (N7) par l'intermédiaire d'un inverseur (P12, N12, P13, N13).
